# EUROPEAN PATENT APPLICATION

(11) **EP 3 331 068 A1**
(43) Date of publication of application: **06.06.2018**
(21) Application number: 16832734.4
(22) Date of filing: 15.07.2016
(51) Int. Cl.: H01M 4/48, C01B 33/113, H01M 4/36

(54) **LITHIUM ION SECONDARY BATTERY NEGATIVE ELECTRODE MATERIAL, PRODUCTION METHOD THEREFOR, AND LITHIUM ION SECONDARY BATTERY**

(30) Priority: 31.07.2015 JP 2015151566
(71) Applicant: Shin-Etsu Chemical Co., Ltd., Tokyo 100-0004 (JP)
(72) Inventor: WATANABE Koichiro, Annaka-shi Gunma 379-0224 (JP); ISHIKAWA Takuya, Annaka-shi Gunma 379-0224 (JP)
(74) Representative: Stoner, Gerard Patrick
(86) International application number: PCT/JP2016/070972
(87) International publication number: WO 2017/022455

(57) **Abstract**

This lithium ion secondary battery negative electrode material is characterized as being particles that contain silicon and that can occlude and release lithium ions, and satisfying 1.00 ≤ P2/P1 ≤ 1.10 when the maximum value of 28.0° ≤ 2θ < 28.2° is defined as P1 and the maximum value of 28.2° ≤ 2θ ≤ 28.6° is defined as P2 in an analysis of an X-ray diffraction pattern.

## Description

### TECHNICAL FIELD

This invention relates to a negative electrode material for use in lithium ion secondary batteries which when used as lithium ion secondary battery negative electrode active material, exhibits a high initial charge/discharge efficiency, high capacity and good cycle performance, a method for preparing the same, a negative electrode using the same, and a lithium ion secondary battery using the same.

### BACKGROUND ART

With the recent rapid progress of potable electronic equipment and communication equipment, secondary batteries having a high energy density are strongly desired from the standpoints of economy and size and weight reduction.

Prior art known attempts for increasing the capacity of such secondary batteries include the use as the negative electrode material of oxides of V, Si, B, Zr, Sn or the like or compound oxides thereof (e.g., Patent Document 1: JP-A H05-174818, Patent Document 2: JP-A H06-60867), melt quenched metal oxides (e.g., Patent Document 3: JP-A H10-294112), silicon oxide (e.g., Patent Document 4: JP 2997741), and Si₂N₂O or Ge₂N₂O (e.g., Patent Document 5: JP-A H11-102705).

Other approaches taken for the purpose of imparting conductivity to the negative electrode material include mechanical alloying of SiO with graphite followed by carbonization (e.g., Patent Document 6: JP-A 2000-243396), coating of silicon particle surfaces with a carbon layer by chemical vapor deposition (e.g., Patent Document 7: JP-A 2000-215887), and coating of silicon oxide particle surfaces with a carbon layer by chemical vapor deposition (e.g., Patent Document 8: JP-A 2002-42806).

These prior art methods are successful in increasing the charge/discharge capacity and the energy density of secondary batteries, but fall short of the market demand partially because of unsatisfactory cycle performance. They are thus not necessarily satisfactory. There is a demand for further improvement in energy density.

More particularly, Patent Document 4 describes a high capacity electrode using silicon oxide as the negative electrode material in a lithium ion secondary cell. As long as the present inventors know, problems arise such as an increased irreversible capacity on the first charge/discharge cycle and a practically unacceptable level of cycle performance. There is left room for improvement.

With respect to the technique of imparting conductivity to the negative electrode material, Patent Document 6 suffers from insufficient conductivity since a uniform carbon coating is not formed due to solid-solid fusion.

The method of Patent Document 7 is successful in forming a uniform carbon coating, but the negative electrode material based on silicon experiences extraordinary expansion and contraction upon absorption and desorption of lithium ions and as a result, fails to withstand practical service. At the same time, the cycle performance declines, and the charge/discharge quantity must be limited in order to prevent such decline. In Patent Document 8, an improvement in cycle performance is ascertainable, but the capacity gradually decreases with the repetition of charge/discharge cycles and suddenly drops after a certain number of cycles, because of precipitation of silicon crystallites, the under-developed structure of the carbon coating and insufficient fusion of the carbon coating to the substrate. This negative electrode material is yet insufficient for use in secondary batteries. Under the circumstances, there is a need to have a negative electrode material which is effective for use in lithium ion secondary batteries and which exhibits a high initial charge/discharge efficiency and good cycle performance while maintaining the advantages of a high battery capacity and low volume expansion associated with silicon oxide material.

### PRIOR ART DOCUMENTS

### PATENT DOCUMENTS

Patent Document 1: JP-A H05-174818
Patent Document 2: JP-A H06-60867
Patent Document 3: JP-A H10-294112
Patent Document 4: JP 2997741
Patent Document 5: JP-A H11-102705
Patent Document 6: JP-A 2000-243396
Patent Document 7: JP-A 2000-215887
Patent Document 8: JP-A 2002-042806

### SUMMARY OF THE INVENTION

### PROBLEMS TO BE SOLVED BY THE INVENTION

An object of the invention is to provide a negative electrode material for use as lithium ion secondary battery negative electrodes, which exhibits a high capacity and good cycle performance while maintaining the advantage of a low coefficient of volume expansion associated with silicon-containing materials, especially silicon oxide materials, a method for preparing the same, a negative electrode using the same, and a lithium ion secondary battery using the same.

### MEANS FOR SOLVING THE PROBLEMS

The inventors have found that when silicon-containing particles capable of occluding and releasing lithium ions and satisfying 1.00 ≤ P2/P1 ≤ 1.10 wherein P1 is the maximum value in the range of 28.0° ≤ 2θ < 28.2° and P2 is the maximum value in the range of 28.2° ≤ 2θ ≤ 28.6° on analysis of an X-ray diffraction pattern are used as a negative electrode material (active material) for lithium ion secondary batteries, there is obtained a lithium ion secondary battery having improved cycle performance. It has also been found that the negative electrode material (active material) is preferably obtained by the preparation method described below. The invention is predicated on these findings.

Accordingly, the invention provides a negative electrode material for use in lithium ion secondary batteries, a preparation method, a negative electrode, and a lithium ion secondary battery, as defined below.
[1] A negative electrode material for lithium ion secondary batteries, comprising silicon-containing particles capable of occluding and releasing lithium ions and satisfying 1.00 ≤ P2/P1 ≤ 1.10 wherein P1 is the maximum value in the range of 28.0° ≤ 2θ < 28.2° and P2 is the maximum value in the range of 28.2° ≤ 2θ ≤ 28.6° on analysis of an X-ray diffraction pattern.
[2] The negative electrode material of [1] wherein the particles of a silicon-containing material capable of occluding and releasing lithium ions are particles of a composite structure having silicon nanoparticles dispersed in a silicon base compound, silicon oxide particles having the general formula: SiOₓ wherein 0.5 ≤ x ≤ 1.6, or a mixture thereof.
[3] The negative electrode material of [1] or [2] wherein the particles of a silicon-containing material capable of occluding and releasing lithium ions are covered on their surface with a carbon coating.
[4] The negative electrode material of [3] wherein the particles covered with a carbon coating have a carbon content of 0.5 to 40% by weight.
[5] The negative electrode material of any one of [1] to [4] wherein the particles have a cumulative 50% by volume diameter (D₅₀) of 0.1 to 30 µm as measured by a laser diffractometry particle size distribution measuring system.
[6] A negative electrode for lithium ion secondary batteries, comprising the negative electrode material of any one of [1] to [5].
[7] A lithium ion secondary battery comprising the negative electrode of [6].
[8] A method for preparing a negative electrode material for lithium ion secondary batteries, comprising the steps of furnishing SiOₓ wherein 0.5 ≤ x ≤ 1.6, coarsely grinding the SiOₓ, collecting a ground fraction having a size of at least 0.5 mm, removing a ground fraction having a size of less than 0.5 mm, and finely milling the SiOₓ fraction having a size of at least 0.5 mm to a cumulative 50% by volume diameter of 0.1 to 30 µm.
[9] A method for preparing a negative electrode material for lithium ion secondary batteries, comprising the step of effecting chemical vapor deposition of carbon on the finely milled SiOₓ fraction wherein 0.5 ≤ x ≤ 1.6, having a cumulative 50% by volume diameter of 0.1 to 30 µm, as obtained in [8], in an organic gas and/or vapor atmosphere which is pyrolyzable to form carbon at a temperature of 800°C to 1,200°C, thereby forming a carbon coating.
[10] The method for preparing a negative electrode material according to [9] wherein the organic gas which is pyrolyzable to form carbon is obtained from at least one raw material selected from the group consisting of methane, ethane, ethylene, acetylene, propane, propylene, butane, butene, pentane, isobutane, hexane, benzene, toluene, xylene, styrene, ethylbenzene, diphenylmethane, naphthalene, phenol, cresol, nitrobenzene, chlorobenzene, indene, coumarone, pyridine, anthracene, phenanthrene, gas light oil, creosote oil and anthracene oil obtained from tar distillation step, and naphtha cracked tar oil.

### ADVANTAGEOUS EFFECTS OF THE INVENTION

By applying the negative electrode material of the invention to a negative electrode in a lithium ion secondary battery, a lithium ion secondary battery having improved cycle performance can be constructed. The preparation method is simple, free of any special complexity, and fully amenable to industrial scale production.

### EMBODIMENT FOR CARRYING OUT THE INVENTION

Now the invention is described in detail.

### [Negative electrode material for lithium ion secondary batteries]

The negative electrode material for lithium ion secondary batteries according to the invention is defined as comprising silicon-containing particles capable of occluding and releasing lithium ions and satisfying 1.00 ≤ P2/P1 ≤ 1.10 wherein P1 is the maximum value in the range of 28.0° ≤ 2θ < 28.2° and P2 is the maximum value in the range of 28.2° ≤ 2θ ≤ 28.6° on analysis of an X-ray diffraction pattern.

The silicon-containing particles capable of occluding and releasing lithium ions (sometimes simply referred to as silicon-containing particles, hereinafter) are preferably silicon particles, particles of a composite structure having silicon nanoparticles dispersed in a silicon base compound, silicon oxide particles having the general formula: SiOₓ wherein 0.5 ≤ x ≤ 1.6, or a mixture thereof. Using these particles, there is obtained a negative electrode material for lithium ion secondary batteries, which exhibits a higher initial charge/discharge efficiency, higher capacity, and better cycle performance.

As used herein, the silicon oxide generally refers to amorphous silicon oxides, and the silicon oxide prior to disproportionation is represented by the general formula: SiOₓ wherein x is 0.5 ≤ x ≤ 1.6. Herein x is preferably 0.8 ≤ x < 1.3, and more preferably 0.8 ≤ x < 1.0. The silicon oxide is obtainable, for example, by heating a mixture of silicon dioxide and metallic silicon to produce a silicon monoxide gas and cooling the gas for precipitation. By mixing a suitable proportion of silicon gas in the silicon monoxide gas, there is obtainable SiOₓ wherein 0.5 ≤ x ≤ 1.0. In particular, SiOₓ wherein x < 1, especially 0.3 ≤ x ≤ 0.9 is obtainable by the method described in JP-A 2007-290919. One exemplary method involves heating a raw material capable of generating silicon oxide gas in the presence of an inert gas or in vacuum at a temperature of 1,100 to 1,600°C, preferably 1,200 to 1,500°C to produce a silicon oxide gas, separately heating metallic silicon in the presence of an inert gas or in vacuum at a temperature of 1,800 to 2,400°C, preferably 2,000 to 2,300°C to produce a silicon gas, and letting a mixture of silicon oxide gas and metallic silicon gas precipitate on a substrate surface. When the value of x in SiOₓ is in the range, the value of x may be controlled in terms of the vapor pressures and charges of the raw material capable of generating silicon oxide gas and metallic silicon. Also, SiOₓ wherein 1.0 ≤ x ≤ 1.6 may be obtained by heat treating SiO (wherein x=1.0), which is obtained by cooling silicon monoxide gas for precipitation, in an oxidizing atmosphere.

The particles of composite structure having silicon nanoparticles dispersed in a silicon base compound may be obtained, for example, by firing a mixture of silicon nanoparticles and a silicon base compound, or by heat treating silicon oxide particles having the general formula: SiOₓ prior to disproportionation, in an inert non-oxidizing atmosphere such as argon at a temperature of at least 400°C, preferably 800 to 1,100°C, to induce disproportionation reaction. In particular, the material obtained by the latter method is preferred in that silicon crystallites are uniformly dispersed. Via the disproportionation reaction as mentioned above, silicon nanoparticles with a size of 1 to 100 nm are obtainable. In the particles of structure having silicon nanoparticles dispersed in silicon oxide, the silicon oxide is desirably silicon dioxide. It may be observed under a transmission electron microscope that silicon nanoparticles (or crystallites) are dispersed in amorphous silicon oxide.

Physical properties of the silicon-containing particles may be selected as appropriate depending on the intended composite particles. For example, the particles preferably have a cumulative 50% diameter (D₅₀) in volume basis distribution of 0.1 to 30 µm, with the lower limit being more preferably at least 0.2 µm, even more preferably at least 0.3 µm. The upper limit is more preferably up to 20 µm, even more preferably up to 10 µm. If D₅₀ is less than 0.1 µm, the BET specific surface area to be described later may be large enough to develop detrimental effects. If D₅₀ is more than 30 µm, the particles used as negative electrode material may be difficult to coat to an electrode. As used herein, the average particle size refers to a volume average particle diameter in particle size distribution measurement by the laser diffraction method.

In grinding particles to the desired particle size, a well-known mill and a well-known classifier are used. Examples of the mill include ball mills and agitated media mills in which grinding media such as balls or beads are moved and a material is ground by utilizing the impact force, friction force or compression force by the kinetic energy; roller mills in which a material is ground by utilizing the compression force produced by rollers; jet mills in which material fragments are forced to collide against the inner liner or each other at a high velocity and ground by the impact force of collision; hammer mills, pin mills and disk mills in which a rotor having hammers, blades or pins anchored thereto is rotated and a material is ground by the impact force of rotation; and colloid mills utilizing the shear force. Grinding may be either wet or dry. To tailor the particle size distribution after grinding, dry classification, wet classification or sieve classification is used. In the dry classification, air stream is mainly used; steps of dispersion, separation (separation between fine and coarse particles), collection (separation between solid and gas) and discharge are carried out sequentially or simultaneously; prior to classification, pretreatment (to adjust water content, dispersion, humidity or the like) may be carried out and the water content and oxygen concentration of air stream used may be adjusted, so that the classification efficiency may not be reduced by the influence of interference between particles, shape of particles, turbulence of air stream, velocity distribution, and static electricity. In the dry mill integrated with a classifier, grinding and classification can be performed at a time until the desired particle size distribution is obtained.

The particles should preferably have a BET specific surface area of 0.5 to 100 m²/g, and more preferably 1 to 20 m²/g. A BET surface area of at least 0.5 m²/g eliminates the risk that particles are weakly bonded when coated on an electrode, leading to a decline of battery characteristics. A surface area of up to 100 m²/g eliminates the risk that the proportion of silicon dioxide available on particle surfaces becomes higher, which leads to a low battery capacity when used as the negative electrode material in a lithium ion secondary battery.

The method for imparting electroconductivity to the silicon-containing particles to improve battery characteristics includes a method of mixing them with conductive particles such as graphite, a method of covering surfaces of composite particles with a carbon coating, and a combination of both methods. Inter alia, the method of covering surfaces of the silicon-containing particles capable of occluding and releasing lithium ions with a carbon coating to form coated particles is preferred. The preferred method of coating with a carbon coating is chemical vapor deposition (CVD).

The CVD method is, for example, a method comprising the step of effecting chemical vapor deposition of carbon on silicon-containing particles capable of occluding and releasing lithium ions, in an organic gas and/or vapor atmosphere which is pyrolyzable to form carbon, at a temperature of 800°C to 1,200°C, preferably 900°C to 1,100°C, thereby forming a carbon coating.

The chemical vapor deposition (CVD) may be performed either under atmospheric pressure or under reduced pressure. The reduced pressure may be a pressure of 50 to 30,000 Pa. The device used in the step of forming a carbon coating may be any of commonly known devices including batchwise furnaces, continuous furnaces such as rotary kilns and roller hearth kilns, and fluidized beds. Inter alia, the rotary kiln which can conduct continuous deposition with agitation can form a uniform coating of carbon efficiently, achieving improvements in battery properties.

Any of various organic substances as mentioned below may be used as the carbon source in forming a carbon coating via CVD although the pyrolysis temperature, deposition rate, and properties of a carbon coating obtained after deposition may largely vary with the identity of substance used. For many substances providing a high deposition rate, the uniformity of a carbon coating on surface is insufficient. In contrast, substances requiring high temperature for pyrolysis have the risk that silicon crystal grains in particles to be coated grow too large during high-temperature deposition, inviting drops of discharge efficiency and cycle performance.

Examples of the source for the organic gas which is pyrolyzable to form carbon include hydrocarbons such as methane, ethane, ethylene, acetylene, propane, propylene, butane, butene, pentane, isobutane, and hexane, monocyclic to tricyclic aromatic hydrocarbons such as benzene, toluene, xylene, styrene, ethylbenzene, diphenylmethane, naphthalene, phenol, cresol, nitrobenzene, chlorobenzene, indene, coumarone, pyridine, anthracene, and phenanthrene, gas light oil, creosote oil and anthracene oil obtained from the tar distillation step, and naphtha cracked tar oil. These substances may be used alone or in admixture.

The coating weight of a carbon coating is preferably 0.5 to 40% by weight, more preferably 1.0 to 30% by weight based on the overall coated particles having a carbon coating. As long as the carbon coating weight is at least 0.5 wt%, a generally sufficient conductivity is maintained, depending on the identity of particles to be coated, which ensures an improvement in cycle performance when a negative electrode for non-aqueous electrolyte secondary batteries is formed. As long as the carbon coating weight is up to 40 wt%, the possibility of occurrence of troubles that no improvements in effects are observed, the proportion of carbon in the negative electrode material is increased, and the charge/discharge capacity lowers when used as the negative electrode material for lithium ion secondary batteries is minimized.

In conjunction with 2θ in the X-ray diffraction pattern analysis, the silicon-containing particles used herein should satisfy the relationship: 1.00 ≤ P2/P1 ≤ 1.10, preferably 1.00 ≤ P2/P1 ≤ 1.07, more preferably 1.00 ≤ P2/P1 ≤ 1.05, wherein P1 is the maximum value in the range of 28.0° ≤ 2θ < 28.2° and P2 is the maximum value in the range of 28.2° ≤ 2θ ≤ 28.6°. Those particles having a P2/P1 value in the range indicate a proper disproportionation and mean that the inclusion amount of metallic silicon having a very large crystal size is not greater than the threshold value.

Those particles having a P2/P1 value in the range are obtainable by removing a fine fraction containing a mixture of metallic silicon and silicon dioxide by the technique described later. They satisfy 1.00 ≤ P2/P1 ≤ 1.10 in a chart obtained by analysis of such particles by an X-ray diffractometry system. A P2/P1 value of less than 1 indicates insufficient disproportionation and a low initial charge/discharge efficiency on use of particles as negative electrode material. A P2/P1 value in excess of 1.1 indicates an excessive progress of disproportionation and a possibility that in the process of firing a mixture of silicon nanoparticles and a silicon base compound to produce composite particles having silicon nanoparticles dispersed in the silicon base compound, a noticeable amount of metallic silicon having a very large crystal size is included in the composite particles.

To produce the particles satisfying 1.00 ≤ P2/P1 ≤ 1.10 wherein P1 is the maximum value in the range of 28.0° ≤ 2θ < 28.2° and P2 is the maximum value in the range of 28.2° ≤ 2θ ≤ 28.6° on analysis of an X-ray diffraction pattern, it is preferable to remove a particulate fraction existing as fines prior to the step of feeding to the finely dividing device as mentioned above. The removal means may be either pneumatic classification or sieve classification. Sometimes the fines existing prior to grinding may contain in admixture metallic silicon and silicon dioxide which are raw materials scattered in the reaction step and it is necessary to remove them.

More specifically, after the above-mentioned SiOₓ wherein 0.5 ≤ x ≤ 1.6 is prepared by heating a mixture of silicon dioxide and metallic silicon to produce silicon monoxide gas and cooling the gas for precipitation as mentioned above, the SiOₓ is coarsely ground on a jaw crusher or the like, and a ground fraction having a size (maximum diameter or maximum length) of at least 0.5 mm, preferably at least 1 mm, more preferably at least 2 mm is collected, and a ground fraction having a smaller size is removed. The step of collecting SiOₓ of the size defined above is preferably classification using a sieve having an opening enough to collect SiOₓ particles of the desired size, thereby collecting SiOₓ particles of the desired size, while the classification may be pneumatic or otherwise.

Next, the SiOₓ fraction having a size of at least 0.5 mm, from which fines with a size of less than 0.5 mm have been removed, is finely milled to obtain SiOₓ having a cumulative 50% by volume diameter (D₅₀) of 0.1 to 30 µm.

Preferably the finely milled SiOₓ is subjected to disproportionation reaction, or chemical vapor deposition (CVD) in an organic gas and/or vapor atmosphere capable of pyrolysis to generate carbon at 800 to 1,200°C, to effect carbon coating on particle surfaces and disproportionation reaction, thereby forming particles of composite structure having silicon nanoparticles dispersed in a silicon base compound, typically SiO₂.

According to the invention, the particles defined above are used as a negative electrode material (active material) to construct a lithium ion secondary battery. Contemplated herein is a negative electrode material for lithium ion secondary batteries comprising the particles. The negative electrode material may be used to prepare a negative electrode, which may be used to construct a lithium ion secondary battery.

### [Negative electrode]

When a negative electrode is prepared using the inventive negative electrode material for lithium ion secondary batteries, a conductive agent such as carbon or graphite may be added thereto. The type of conductive agent used herein is not particularly limited as long as it is an electronically conductive material which does not undergo decomposition or alteration in the battery. Illustrative conductive agents include metals in powder or fiber form such as Al, Ti, Fe, Ni, Cu, Zn, Ag, Sn and Si, natural graphite, synthetic graphite, various coke particles, meso-phase carbon, vapor phase grown carbon fibers, pitch base carbon fibers, PAN base carbon fibers, and graphite obtained by firing various resins.

The negative electrode may be prepared, for example, as a shaped body by the following method.

The negative electrode material and optional additives such as a conductive agent and a binder (e.g., polyimide resin) are kneaded in a solvent such as N-methylpyrrolidone or water to form a paste mix, which is applied to a sheet as a current collector. The current collector used herein may be of any materials commonly used as the negative electrode current collector such as copper and nickel foils while it is not particularly limited in thickness and surface treatment.

Notably the technique of shaping the mix into a sheet is not particularly limited and any well-known techniques may be used.

### [Lithium ion secondary battery]

The lithium ion secondary battery is a lithium ion secondary battery comprising at least a positive electrode, a negative electrode, and a lithium ion-conductive non-aqueous electrolyte wherein the inventive negative electrode material is used and contained in the negative electrode. The inventive lithium ion secondary battery is characterized by comprising a negative electrode made of the negative electrode material comprising the coated particles. The materials of the positive electrode, electrolyte, and separator and the battery design may be well-known ones and are not particularly limited. When the negative electrode material is used to form a negative electrode for lithium ion secondary batteries, the resulting negative electrode shows satisfactory cell properties (charge/discharge capacity and cycle performance), especially improved cycle durability.

For example, the positive electrode active material used herein may be selected from transition metal oxides such as LiCoO₂, LiNiO₂, LiMn₂O₄, V₂O₅, MnO₂, TiS₂ and MoS₂, lithium, and chalcogen compounds.

The electrolytes used herein may be lithium salts such as lithium hexafluorophosphate and lithium perchlorate in non-aqueous solution form. Examples of the non-aqueous solvent include propylene carbonate, ethylene carbonate, diethyl carbonate, dimethoxyethane, γ-butyrolactone and 2-methyltetrahydrofuran, alone or in admixture. Use may also be made of other various non-aqueous electrolytes and solid electrolytes.

### EXAMPLES

Examples and Comparative Examples are given below by way of illustration and not by way of limitation.

### [Example 1]

SiOₓ was crushed on a jaw crusher (by Maekawa Kogyosho Co., Ltd.) and sieved through a vibration sieve having an opening of 1 mm, and an undersize ground fraction was removed. An oversize SiOₓ fraction was milled for 80 minutes on a ball mill (by Makino Corp.) using alumina balls with a diameter of 10 mm as milling media. On analysis by a laser diffraction particle size distribution analyzer SALD-3100 (by Shimadzu Corp.) at a refractive index 3.90-0.01i, the resulting particles had a cumulative 50% by volume diameter (D₅₀) of 4.6 µm. On analysis by an oxygen/nitrogen elemental analyzer OCN836 (by LECO Corp., same, hereinafter), the particles had an oxygen content of 36.0 wt%, indicating SiOₓ wherein x=0.99.

The particles, 100 g, was spread in a tray to form a powder layer of 10 mm thick, which was placed in a batchwise heating furnace. While the furnace was evacuated by a rotary vane pump, the furnace was heated at a heating rate of 200°C/hr to an internal temperature of 1,000°C. Once the temperature of 1,000°C was reached, carbon coating treatment was carried out for 10 hours while feeding methane into the furnace at a flow rate of 0.3 L/min. The methane feed was interrupted, and the furnace was cooled, obtaining 106 g of black particles.

The black particles thus obtained were conductive particles having a carbon coating weight of 4.8 wt%.

The black particles were analyzed by an X-ray diffraction unit D2 PHASER (by Bruker AXS K.K.). A step width of 0.015° was set so as to gain detailed data near 2θ=28.4°. Provided that P1 is the maximum value in the range of 28.0° ≤ 2θ < 28.2° and P2 is the maximum value in the range of 28.2° ≤ 2θ ≤ 28.6°, the P1 value was 44644 counts and the P2 value was 46875 counts, from which a P2/P1 value of 1.05 was calculated.

### <Cell test>

A cell using the particles as a negative electrode active material was evaluated by the following test.

First, a slurry was prepared by mixing 45% by weight of the negative electrode material, 45% by weight of artificial graphite (average particle size 10 µm), and 10% by weight of polyimide, and adding N-methylpyrrolidone thereto.

The slurry was coated onto a copper foil of 12 µm gage and dried at 80°C for 1 hour. Using a roller press, the coated foil was shaped under pressure into an electrode sheet. The electrode sheet was vacuum dried at 350°C for 1 hour, after which 2 cm² discs were punched out as the negative electrode.

To evaluate the charge/discharge properties of the negative electrode, a test lithium ion secondary cell was constructed using a lithium foil as the counter electrode. The electrolyte solution used was a non-aqueous electrolyte solution of lithium hexafluorophosphate in a 1/1 (by volume) mixture of ethylene carbonate and diethyl carbonate in a concentration of 1 mol/liter. The separator used was a microporous polyethylene film of 30 µm thick.

The lithium ion secondary cell thus constructed was allowed to stand overnight at room temperature. Using a secondary cell charge/discharge tester (by Nagano K.K.), a charge/discharge test was carried out on the cell. Charging was conducted with a constant current flow of 0.5 mA/cm² until the voltage of the test cell reached 0 V, and after reaching 0 V, continued with a reduced current flow so that the cell voltage was kept at 0 V, and terminated when the current flow decreased below 40 µA/cm². Discharging was conducted with a constant current flow of 0.5 mA/cm² and terminated when the cell voltage reached 1.4 V, from which a discharge capacity was determined.

By repeating the above operation, the charge/discharge test was carried out 50 cycles on the lithium ion secondary cell. The results are shown in Table 1. It is seen that the cell was a lithium ion secondary cell having a high capacity and excellent cycle performance as demonstrated by an initial discharge capacity of 1,781 mAh/g and a capacity retention of 94% after 50 cycles.

### [Example 2]

Particles of SiOₓ wherein x=0.99 having a D₅₀ of 4.6 µm milled as in Example 1, 100 g, was similarly placed in a batchwise heating furnace. While the furnace was evacuated by a rotary vane pump, the furnace was heated at a heating rate of 200°C/hr to an internal temperature of 1,100°C. Once the temperature of 1,200°C was reached, carbon coating treatment was carried out for 6 hours while feeding methane into the furnace at 0.3 L/min. The methane feed was interrupted, and the furnace was cooled.

The black particles thus obtained were conductive particles having a carbon coating weight of 10.3 wt%.

The particles were analyzed by an X-ray diffraction unit as in Example 1, finding a P2/P1 value of 1.09.

### [Example 3]

Particles of SiOₓ wherein x=0.99 having a D₅₀ of 4.6 µm milled as in Example 1, 100 g, was subjected to carbon coating treatment as in Example 1 except that the temperature was 800°C and the treatment time was 17 hours.

The black particles thus obtained were conductive particles having a carbon coating weight of 4.6 wt%.

The particles were analyzed by an X-ray diffraction unit as in Example 1, finding a P2/P1 value of 1.01.

### [Example 4]

Particles of SiOₓ wherein x=0.99 having a D₅₀ of 4.6 µm milled as in Example 1, 100 g, was mixed with 0.2 g of metallic silicon having a D₅₀ of 3.6 µm until uniform. This was subjected to carbon coating treatment as in Example 1.

The black particles thus obtained were conductive particles having a carbon coating weight of 4.8 wt%.

The particles were analyzed by an X-ray diffraction unit as in Example 1, finding a P2/P1 value of 1.06.

### [Example 5]

A setup included a reaction tube of graphite having a diameter 120 mm, a heater mounted outside for heating the tube, and two trays inserted in the tube at two positions in different temperature zones of the tube. The high-temperature zone (first raw material tray) was charged with 500 g of silicon particles (average particle size 30 µm), and the low-temperature zone (second raw material tray) was charged with 500 g of silicon oxide particles (average particle size 50 µm). A vacuum pump was actuated to evacuate the furnace interior to below 0.1 Torr, and the heater was energized to heat the first raw material tray at a temperature of 2,200°C. At this point, the second raw material tray was at a temperature of 1,430°C. This operation was continued for 10 hours, after which the furnace was cooled down, allowing a precipitate to deposit. The precipitate was milled as in Example 1, obtaining particles with a D₅₀ of 4.7 µm. The particles had an oxygen content of 27.2 wt%, indicating SiOₓ wherein x=0.66. The particles were subjected to graphite coating as in Example 1.

The particles were analyzed by an X-ray diffraction unit as in Example 1, finding a P2/P1 value of 1.09.

### [Example 6]

Particles of SiOₓ wherein x=0.99 having a D₅₀ of 4.6 µm milled as in Example 1, 100 g, was heated at 600°C under atmospheric pressure in air atmosphere and held at the temperature for 8 hours. The furnace was cooled down. On analysis, the particles had an oxygen content of 41.2 wt%, indicating SiOₓ wherein x=1.23. The particles were subjected to graphite coating as in Example 1.

The particles were analyzed by an X-ray diffraction unit as in Example 1, finding a P2/P1 value of 1.03.

### [Comparative Example 1]

Particles of SiOₓ wherein x=0.99 having a D₅₀ of 4.6 µm milled as in Example 1, 100 g, was mixed with 0.5 g of metallic silicon having a D₅₀ of 3.6 µm until uniform. This was subjected to carbon coating treatment as in Example 1.

The black particles thus obtained were conductive particles having a carbon coating weight of 4.7 wt%.

The particles were analyzed by an X-ray diffraction unit as in Example 1, finding a P2/P1 value of 1.12.

### [Comparative Example 2]

Particles of SiOₓ wherein x=0.99 having a D₅₀ of 4.6 µm milled as in Example 1, 100 g, was mixed with 2 g of metallic silicon having a D₅₀ of 3.6 µm until uniform. This was subjected to carbon coating treatment as in Example 1.

The black particles thus obtained were conductive particles having a carbon coating weight of 4.8 wt%.

The particles were analyzed by an X-ray diffraction unit as in Example 1, finding a P2/P1 value of 1.29.

### [Comparative Example 3]

Particles of SiOₓ wherein x=0.99 having a D₅₀ of 4.6 µm milled as in Example 1, 100 g, was subjected to carbon coating treatment as in Example 1 except that the temperature was 700°C and the treatment time was 35 hours.

The black particles thus obtained were conductive particles having a carbon coating weight of 4.5 wt%.

The particles were analyzed by an X-ray diffraction unit as in Example 1, finding a P2/P1 value of 0.98.

### [Comparative Example 4]

The SiOₓ crushed on a jaw crusher in Example 1 was milled on a ball mill without sieving, yielding particles having a D₅₀ of 4.3 µm. The particles, 100 g, were subjected to carbon coating treatment as in Example 1.

The black particles thus obtained were conductive particles having a carbon coating weight of 5.2 wt%.

The particles were analyzed by an X-ray diffraction unit as in Example 1, finding a P2/P1 value of 1.13.

The particle size and cell properties of Examples and Comparative Examples are tabulated in Table 1. It is proven that Comparative Examples are lithium ion secondary cells having inferior cell properties, especially inferior cycle properties to the negative electrode materials of Examples.

**[Table 1]**

| | | Carbon coating weight (wt%) | P1 (count) | P2 (count) | P2/P1 (-) | Initial discharge capacity (mAh/g) | Capacity retention after 50 cycles (%) |
|---|---|---|---|---|---|---|---|
| Example | 1 | 4.8 | 44644 | 46875 | 1.05 | 1,781 | 94 |
| | 2 | 10.3 | 78126 | 85158 | 1.09 | 1,689 | 90 |
| | 3 | 4.6 | 32468 | 32793 | 1.01 | 1,703 | 92 |
| | 4 | 4.8 | 48702 | 51624 | 1.06 | 1,787 | 92 |
| | 5 | 5.0 | 58086 | 63308 | 1.09 | 1,928 | 89 |
| | 6 | 5.2 | 40911 | 42138 | 1.03 | 1,478 | 95 |
| Comparative Example | 1 | 4.7 | 49717 | 55683 | 1.12 | 1,790 | 81 |
| | 2 | 4.8 | 79141 | 102092 | 1.29 | 1,876 | 58 |
| | 3 | 4.5 | 30439 | 29830 | 0.98 | 1,613 | 87 |
| | 4 | 5.2 | 44689 | 50348 | 1.13 | 1,805 | 86 |

## Claims

1. A negative electrode material for lithium ion secondary batteries, comprising silicon-containing particles capable of occluding and releasing lithium ions and satisfying 1.00 ≤ P2/P1 ≤ 1.10 wherein P1 is the maximum value in the range of 28.0° ≤ 2θ < 28.2° and P2 is the maximum value in the range of 28.2° ≤ 2θ ≤ 28.6° on analysis of an X-ray diffraction pattern.

2. The negative electrode material of claim 1 wherein the particles of a silicon-containing material capable of occluding and releasing lithium ions are particles of a composite structure having silicon nanoparticles dispersed in a silicon base compound, silicon oxide particles having the general formula: SiOₓ wherein 0.5 ≤ x ≤ 1.6, or a mixture thereof.

3. The negative electrode material of claim 1 or 2 wherein the particles of a silicon-containing material capable of occluding and releasing lithium ions are covered on their surface with a carbon coating.

4. The negative electrode material of claim 3 wherein the particles covered with a carbon coating have a carbon content of 0.5 to 40% by weight.

5. The negative electrode material of any one of claims 1 to 4 wherein the particles have a cumulative 50% by volume diameter (D₅₀) of 0.1 to 30 µm as measured by a laser diffractometry particle size distribution measuring system.

6. A negative electrode for lithium ion secondary batteries, comprising the negative electrode material of any one of claims 1 to 5.

7. A lithium ion secondary battery comprising the negative electrode of claim 6.

8. A method for preparing a negative electrode material for lithium ion secondary batteries, comprising the steps of furnishing SiOₓ wherein 0.5 ≤ x ≤ 1.6, coarsely grinding the SiOₓ, collecting a ground fraction having a size of at least 0.5 mm, removing a ground fraction having a size of less than 0.5 mm, and finely milling the SiOₓ fraction having a size of at least 0.5 mm to a cumulative 50% by volume diameter of 0.1 to 30 µm.

9. A method for preparing a negative electrode material for lithium ion secondary batteries, comprising the step of effecting chemical vapor deposition of carbon on the finely milled SiOₓ fraction wherein 0.5 ≤ x ≤ 1.6, having a cumulative 50% by volume diameter of 0.1 to 30 µm, as obtained in claim 8, in an organic gas and/or vapor atmosphere which is pyrolyzable to form carbon at a temperature of 800°C to 1,200°C, thereby forming a carbon coating.

10. The method for preparing a negative electrode material according to claim 9 wherein the organic gas which is pyrolyzable to form carbon is obtained from at least one raw material selected from the group consisting of methane, ethane, ethylene, acetylene, propane, propylene, butane, butene, pentane, isobutane, hexane, benzene, toluene, xylene, styrene, ethylbenzene, diphenylmethane, naphthalene, phenol, cresol, nitrobenzene, chlorobenzene, indene, coumarone, pyridine, anthracene, phenanthrene, gas light oil, creosote oil and anthracene oil obtained from tar distillation step, and naphtha cracked tar oil.
